(19) **Europäisches Patentamt / European Patent Office / Office européen des brevets**

(11) **EP 1 511 176 B1**

(12) ## EUROPÄISCHE PATENTSCHRIFT

(45) Veröffentlichungstag und Bekanntmachung des Hinweises auf die Patenterteilung:
**14.11.2007   Patentblatt 2007/46**

(51) Int Cl.:
***H03M 1/12*** *(2006.01)*

(21) Anmeldenummer: **04103965.2**

(22) Anmeldetag: **18.08.2004**

(54) **Vorrichtung sowie Verfahren zum Digitalisieren von parallel eingehenden Analogsignalen**

Apparatus and method to digitise parallel inputted analog signals

Méthode et appareil pour digitaliser plusieurs signaux analogiques en parallèle

(84) Benannte Vertragsstaaten:
**DE FR GB IT**

(30) Priorität: **28.08.2003   DE 10339644**

(43) Veröffentlichungstag der Anmeldung:
**02.03.2005   Patentblatt 2005/09**

(73) Patentinhaber: **ROBERT BOSCH GMBH**
**70442 Stuttgart (DE)**

(72) Erfinder:
• **Spreitz, Gerald**
  **30880 Laatzen (DE)**

• **Querol Alsina, Emilio**
  **12500 Vinaros (Castellon) (ES)**

(56) Entgegenhaltungen:
WO-A-03/055207          DE-C- 10 042 959
US-B1- 6 486 809

• **THILMAN D ET AL: "SCHNELLE VIERKANALIGE ANALOGEINGABEBAUGRUPPE FUR K 1520" RADIO FERNSEHEN ELEKTRONIK, VEB VERLAG TECHNIK. BERLIN, DE, Bd. 37, Nr. 7, Januar 1988 (1988-01), Seiten 456-458, XP000097474 ISSN: 1436-1574**

**Beschreibung**

**Technisches Gebiet**

Die vorliegende Erfindung betrifft eine Vorrichtung sowie ein Verfahren zum Vorrichtung zum Wandeln von mindestens zwei parallel eingehenden Analogsignalen zu mittels digitaler Signalprozessoren zu verarbeitenden Digitalsignalen, wobei mindestens ein erstes Analogsignal der eingehenden Analogsignale mindestens einem ersten Signalpfad zuordbar ist und mindestens ein weiteres, insbesondere mindestens ein zweites, Analogsignal der eingehenden Analogsignale mindestens einem weiteren, insbesondere mindestens einem zweiten, Signalpfad zuordbar ist.

**Stand der Technik**

A[nalog]/D[igital]-Wandler sind ein unverzichtbarer Bestandteil moderner Kommunikationssysteme; allerdings stellen Analog/Digital-Wandler mit ihren hohen technischen Anforderungen und Spezifikationen einen erheblichen Kostenfaktor dar, der im Zuge der fortschreitenden Miniaturisierung der digitalen Logik an Gewicht gewinnt. Dieser Kostenfaktor tritt insbesondere bei Rundfunkempfängern zutage, bei denen es oftmals erwünscht ist, mehrere Systeme gleichzeitig zu empfangen, so dass dann konventionellerweise eine entsprechende Anzahl an Analog/Digital-Wandlern benötigt wird.

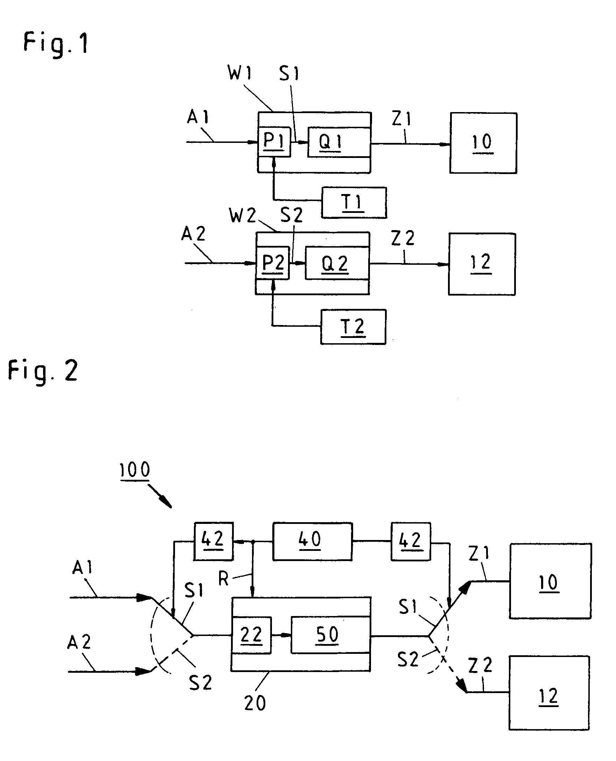

Wie Figur 1 entnehmbar ist, wird dies gemäß dem Stand der Technik realisiert, indem für jedes eingehende Analogsignal A1 bzw. A2 pro Signalpfad S1 bzw. S2 ein eigener Analog/Digital-Wandler W1 bzw. W2 zum Digitalisieren des Analogsignals A1 bzw. A2 eingesetzt werden muß.

Hierbei durchläuft das erste, in Figur 1 obere Analogsignal A1 eine Abtasteinheit P1, die durch eine Taktgeberinheit T1 getaktet wird. Anschließend werden die Abtastwerte des abgetasteten Analogsignals A1 in einer der Abtasteinheit P1 nachgeschalteten Quantisierungseinheit Q1 digitalisiert und in einem der Quantisierungseinheit Q1 nachgeschalteten digitalen Signalprozessor 10 weiterverarbeitet; entsprechendes gilt für das zweite, in Figur 1 untere Analogsignal A2 wie auch gegebenenfalls für weitere, gleichzeitig mit dem ersten Analogsignal A1 sowie mit dem zweiten Analogsignal A2 eintreffende weitere Analogsignale.

Die Vorgehensweise gemäß dem anhand Figur 1 veranschaulichten Stand der Technik erfordert für jedes System einen eigenen Analog/Digital-Wandler im Signalpfad, was nachteiligerweise mit hohen Kosten sowie mit großem Platzbedarf verbunden ist und das Ziel der Miniaturisierung von Kommunikationssystemen konterkariert.

Aus der WO 03/055207 ist eine Vorrichtung zum Wandeln von mindestens zwei parallel eingehenden Analogsignalen zu mittels digitaler Signalprozessoren zu verarbeitenden Digitalsignalen bekannt. Die beiden parallel eingehenden Analogsignale werden zwei unterschiedlichen Signalpfaden zugeordnet in denen sie mittels eines Analog/Digital-Wandlers gleichzeitig wandelbar sind. Es erfolgt dort eine Abtastung der eingehenden Analogsignale in Abhängigkeit eines Taktsignals in unterschiedlichen Zeitintervallen.

Bei der DE 100 42 959 C1 werden ebenfalls mehrere analoge Signale mit nur einem Analog-Digital-Wandler gewandelt. Dort werden die analogen Einzelsignale spektral gespreizt und als Summensignal gemeinsam analog-digital-gewandelt.

Darstellung der Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, eine Vorrichtung der eingangs genannten Art sowie ein Verfahren der eingangs genannten Art so weiterzuentwickeln, dass Baugröße und Kosten der Vorrichtung bzw. der Durchführung des Verfahrens minimiert werden.

Diese Aufgabe wird durch eine Vorrichtung mit den im Anspruch 1 angegebenen Merkmalen sowie durch ein Verfahren mit den im Anspruch 4 angegebenen Merkmalen gelöst.

Vorteilhafte Ausgestaltungen und zweckmäßige Weiterbildungen der vorliegenden Erfindung sind in den jeweiligen Unteransprüchen gekennzeichnet.

Die Lehre gemäß der vorliegenden Erfindung basiert demnach auf einer Anordnung zur mehrkanaligen Quantisierung in einem einzigen Analog/Digital-Wandler mit gleichen Abtastraten oder mit ungleichen Abtastraten. In diesem Zusammenhang wird unter der auch als Abtastfrequenz bezeichneten Abtastrate die Frequenz verstanden, mit der aus dem analogen Eingangssignal momentane Spannungsproben als Abtastwerte entnommen werden.

Diese Abtastwerte oder Spannungsproben werden anschließend in der Quantisierungseinheit des Analog/Digital-Wandlers digitalisiert, wobei in der erfindungsgemäß vorgeschlagenen Anordnung die wesentliche Komponente des Analog/Digital-Wandlers, das heißt die Quantisierungseinheit im Unterschied zum Stand der Technik für sämtliche, insbesondere für beide, Kanäle oder Signalwege genutzt wird.

Dies stellt im Vergleich zum Stand der Technik insofern einen deutlichen Gewinn dar, als durch Einsparen der weiteren Analog/Digital-Wandler sowohl die Baugröße als auch die Kosten erheblich reduziert werden können.

Gemäß einer vorteilhaften Ausführungsform der vorliegenden Erfindung arbeitet die dem Analog/Digital-Wandler zugeordnete Quantisierungseinheit mit einer im Vergleich zu aus dem Stand der Technik bekannten Einzelsystemen doppelten Rate. Dabei wird die Quantisierungseinheit abwechselnd dem einen oder dem anderen, durch den jeweiligen Kanal bzw. Signalpfad definierten System zugeordnet, so dass ein Zweikanal-Quantisierer mit symmetrischer Abtastrate gebildet wird.

In diesem Zusammenhang gibt Abtastfrequenz oder Abtastrate an, wie oft in einer Sekunde der Analog/Digital-Wandler vom eingehenden Analogsignal einen Abtastwert bestimmt. Die Abtastfrequenz oder Abtastrate ist für die Qualität der A[nalog]/D[igital]-Wandlung entscheidend; so sind bei Soundkarten zum Beispiel Abtastraten von etwa vier Kilohertz bis etwa 44 Kilohertz gebräuchlich; im Studiobereich werden Abtastfrequenzen bis zu 96 Kilohertz und darüber verwendet (24 Bit-Wandler bis 36 Bit-Wandler).

In einer erfindungswesentlichen Weiterbildung sowohl der Vorrichtung als auch des Verfahrens kann das vorstehende Prinzip nicht nur für zwei, sondern auch für N (> 2) Kanäle oder Pfade realisiert werden, wobei alle Pfade bzw. Systeme mit dem gleichen Abtasttakt betrieben werden; in diesem Falle ist dann ein N-Kanal-Quantisierer mit symmetrischer Abtastrate gebildet.

Gemäß einer zur symmetrischen Variante alternativen Ausführungsform (= sogenannte asymmetrische Variante) der Vorrichtung gemäß der vorliegenden Erfindung sowie des Verfahrens gemäß der vorliegenden Erfindung wird ein Kanal oder Signalpfad mit der ganzen (= vollen) Abtastrate betrieben, wohingegen der oder die weiteren Kanäle oder Signalpfade mit einem insbesondere ganzzahligen Bruchteil dieser Abtastrate betrieben werden.

Während die symmetrische Variante der vorliegenden Erfindung sinnvollerweise für zwei im wesentlichen gleichartige analoge Eingangssignale mit ähnlicher oder gleicher Frequenzbandbreite eingesetzt werden sollte, empfiehlt sich die Verwendung der asymmetrischen Variante der vorliegenden Erfindung für den Fall, dass das erste analoge Eingangssignal eine höhere Frequenzbandbreite als das weitere analoge Eingangssignal (oder als die weiteren analogen Eingangssignale) aufweist, denn für diese(s) schmalbandigere(n) Analogsignal(e) genügt eine niedrigere Abtastrate als für das erste Analogsignal.

Soll nun bei der asymmetrischen Variante der vorliegenden Erfindung exemplarischerweise jeder fünfte Abtastwert des auf dem zweiten Kanal oder Pfad geführten zweiten Analogsignals quantisiert werden (<--> ganzzahliger Bruchteil = ein Fünftel), so können vier Abtastwerte des auf dem ersten Kanal oder Pfad geführten ersten Analogsignals quantisiert werden, woraufhin dann der fünfte Abtastwert des zweiten Analogsignals quantisiert wird; sodann können wieder vier Abtastwerte des ersten Analogsignals quantisiert werden, dann wieder der fünfte Abtastwert auf dem zweiten Kanal oder Pfad, und so weiter.

Das Ausgangssignal der dem Analog/Digital-Wandler zugeordneten, insbesondere im Analog/Digital-Wandler integrierten, Quantisierungseinheit wird den digitalen Signalverarbeitungspfaden zugeführt. Da der erste Pfad weiterhin auf der vollen Abtastrate läuft, jeder N-te Wert (in vorstehendem Beispiel: jeder fünfte Wert) aber dem zweiten Pfad zugeordnet ist, ist das abgetastete und sodann quantisierte erste Signal zu ergänzen, denn jeder N-te Wert (in vorstehendem Beispiel: jeder fünfte Wert) des ersten Signals fehlt:

Ein derartiges Ergänzen des quantisierten ersten Signals ist über eine an dieses quantisierte erste Signal angepaßte Interpolation möglich, was jedoch mit einem gewissen Realisierungsaufwand, insbesondere auch mit einem gewissen Rechenaufwand, verbunden ist.

Eine noch vorteilhaftere Variante der Signalergänzung besteht darin, die fehlenden Abtastwerte im ersten Kanal oder Signalpfad durch Null, das heißt durch einen verschwindenden Abtastwert zu ersetzen. Eine derartige Vorgehensweise stellt zwar zunächst eine Veränderung des Signals im ersten Kanal oder Pfad dar; unter der Bedingung, dass nicht die volle Nyquist-Bandbreite des abgetasteten Signals genutzt wird, sondern nur ein Teilband mit einer bestimmten Bandbreite herausgefiltert werden kann oder soll, haben das Ersetzen durch Null und die damit verbundene Signalveränderung jedoch lediglich vernachlässigbar geringe, die Qualität des Empfängers nicht beeinträchtigende Auswirkungen auf die Ergebnisse der Signalverarbeitung, das heißt auf das am Ende erzielbare Signal/Rausch-Verhältnis (sogenannte "s[ignal]/n[oise]-ratio") oder auf die Bitfehlerrate.

In diesem Zusammenhang sagt das auf Kotelnikov zurückgehende und von Nyquist weiterentwickelte Abtasttheorem aus, dass eine Zeitfunktion, deren Frequenzspektrum im Frequenzband von null Hertz bis B Hertz liegt, durch ihre Ordinaten an äquidistanten Punkten eindeutig bestimmt ist, sofern diese Punkte nicht weiter als 1/2B Sekunden voneinander entfernt sind.

Um aus den abgetasteten Spannungswerten das ursprüngliche Signal reproduzieren zu können, muß die Abtastrate mindestens doppelt so groß wie die Abtastrate des abgetasteten Signals sein. Hat das abzutastende Signal beispielsweise eine Frequenz von 500 Kilohertz, dann muß die Abtastrate ein Megahertz oder mehr betragen.

Das Abtasttheorem ist für die Anwendung der Informationstheorie auf kontinuierliche Signale fundamental, weil es die Darstellung eines kontinuierlichen Signals endlicher Dauer durch eine endliche Anzahl von Freiheitsgraden, also auch als Binärsignal, gestattet. Bei Rundfunkanwendungen bleiben die Ergebnisse der Signalverarbeitung also üblicherweise unverfälscht, denn bei Rundfunkanwendungen wird nur der gewünschte Kanal mit dem gewünschten Programm ausgewählt.

Die vorliegende Erfindung betrifft des weiteren eine Schaltungsanordnung, insbesondere einen integrierten Schaltkreis, aufweisend eine Vorrichtung gemäß der vorstehend dargelegten Art.

Die vorliegende Erfindung betrifft schließlich die Verwendung mindestens einer Vorrichtung gemäß der vorstehend dargelegten Art und/oder mindestens einer Schaltungsanordnung gemäß der vorstehend dargelegten Art und/oder eines Verfahrens gemäß der vorstehend dargelegten Art in digitalen Kommunikationssystemen, insbesondere in digitalen Rundfunkempfangssystemen.

**Kurze Beschreibung der Zeichnungen**

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die den Ansprüchen 1 und 7 nachgeordneten Ansprüche verwiesen, andererseits werden weitere Ausgestaltungen, Merkmale und Vorteile der vorliegenden Erfindung nachstehend anhand der beiden durch die Figuren 2 bis 4 veranschaulichten Ausführungsbeispiele näher erläutert.

Es zeigt:

Fig. 1 in schematischer Darstellung eine Vorrichtung gemäß dem Stand der Technik;

Fig. 2 in schematischer Darstellung ein erstes Ausführungsbeispiel der Vorrichtung gemäß der vorliegenden Erfindung, die nach dem Verfahren gemäß der vorliegenden Erfindung arbeitet;

Fig. 3 in schematischer Darstellung ein zweites Ausführungsbeispiel der Vorrichtung gemäß der vorliegenden Erfindung, die nach dem Verfahren gemäß der vorliegenden Erfindung arbeitet; und

Fig. 4 in schematischer Darstellung eine systemtheoretische Überlegung für eine korrekte Signalergänzung bzw. Signalgewinnung bei der Vorrichtung aus Fig. 3.

Gleiche oder ähnliche Ausgestaltungen, Elemente oder Merkmale sind in den Figuren 1 bis 4 mit identischen Bezugszeichen versehen.

**Bester Weg zur Ausführung der Erfindung**

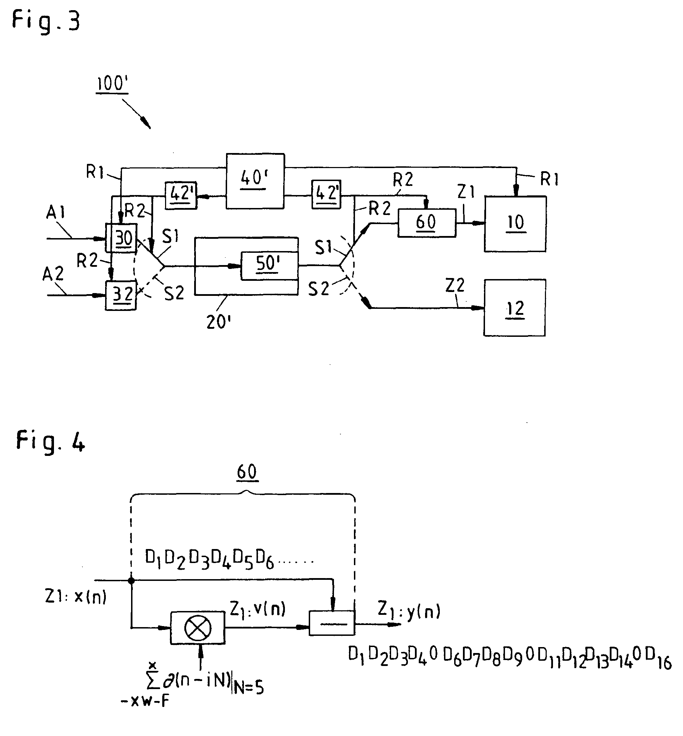

Im folgenden werden eine beispielsweise im Rahmen einer Schaltungsanordnung, wie etwa im Rahmen eines integrierten Schaltkreises, implementierte Vorrichtung 100 (= erstes Ausführungsbeispiel; vgl. Figur 2) bzw. 100' (= zweites Ausführungsbeispiel; vgl. Figur 3) gemäß der vorliegenden Erfindung sowie ein hierauf bezogenes Verfahren zum Wandeln von zwei parallel eingehenden Analogsignalen A1, A2 zu entsprechenden Digitalsignalen Z1, Z2 exemplarisch erläutert.

Diese Digitalsignale Z1, Z2 werden mittels digitaler Signalprozessoren 10, 12 (= sogenannte D[igital]S[ignal]P[rocessor]s) weiterverarbeitet. Hierbei handelt es sich bei den D[igital]S[ignal]P[rocessor]s 10, 12 um elektronische Baustein zur Bearbeitung der digitalisierten Audiosignale gemäß einem vorgegebenen Algorithmus, wobei eine Übersteuerung der digitalen Signalprozessoren 10, 12 nach Möglichkeit zu vermeiden ist.

Das von einer (aus Gründen der Übersichtlichkeit der Darstellung in den Figuren 2 und 3 nicht explizit gezeigten) Antenne eingehende erste Analogsignal A1 ist einem ersten Signalpfad S1 (= erster Kanal) zugeordnet. Das von derselben Antenne oder einer (aus Gründen der Übersichtlichkeit der Darstellung in den Figuren 2 und 3 ebenfalls nicht explizit gezeigten) weiteren Antenne gelieferte zweite Analogsignal A2 ist einem zweiten Signalpfad S2 (= zweiter Kanal) zugeordnet.

Hierbei ist die Besonderheit des ersten Ausführungsbeispiels gemäß Figur 2 sowie des zweiten Ausführungsbeispiels gemäß Figur 3 darin zu sehen, dass die beiden Analogsignale A1, A2 mittels eines einzigen A[nalog]/D[igital]-Wandlers 20 (vgl. Figur 2) bzw. 20' (vgl. Figur 3) gleichzeitig digitalisiert werden können.

Hierbei handelt es sich bei einem A[nalog]/D[igital]-Wandler (= sogenannter A[nalog]D[igital]C[onverter]) um einen elektronischen Bausteine oder um eine elektronische Einheit zur Umwandlung von analogen Signalen (Spannungsverlauf) in digitale Signale. Bei der Analog/Digital-Wandlung werden die analogen Signale zunächst in einem zeitlichen Raster abgetastet (Abtasttheorem), danach quantifiziert und in einem Dualsystem kodiert.

Analog/Digital-Wandler arbeiten grundsätzlich nach unterschiedlichen Wandlungsverfahren, die sich in der Wandlungsgeschwindigkeit, der Quantisierung, der Kodierung und der Auflösung, mit der die analogen Signale digital nachgebildet werden, unterscheiden.

Die Umwandlung der analogen Signale in die digitalen Signale ist notwendig, um eine Bearbeitung des binären Signals durch einen Computer oder durch die digitalen Signalprozessoren 10, 12 zu ermöglichen. Je größer die Bitrate bei der Wandlung ist, umso qualitativ höherwertiger ist das Ergebnis der Wandlung. Im häuslichen Bereich werden derzeit überwiegend 16 Bit-Wandler eingesetzt, im professionellen Bereich 20 Bit-Wandler bis 36 Bit-Wandler.

Beim ersten Ausführungsbeispiel der vorliegenden Erfindung gemäß Figur 2 werden in einer im Analog/Digital-Wandler 20 integrierten Abtasteinheit 22 das erste, in Figur 2 obere Analogsignal A1 und das zweite, in Figur 2 untere Analogsignal A2 mittels einer Abtastrate R symmetrisch und abwechselnd unter Erhalt von jeweiligen Abtastwerten abgetastet. Den Takt für diese symmetrische Abtastung der beiden Signalpfade S1, S2 liefert eine Taktgebereinheit 40, die den Analog/Digital-Wandler 20, und hierbei insbesondere den ersten Signalpfad S1 und den zweiten Signalpfad S2, mit der Abtastrate R beaufschlagt.

Aus der Darstellung gemäß Figur 2 ist ersichtlich, dass der von der Takt(geber)einheit 40 zur Verfügung gestellte Takt R an insgesamt fünf Stellen in der Vorrichtung 100 genutzt wird, nämlich

- beim eingehenden ersten Analogsignal A1,
- beim eingehenden zweiten Analogsignal A2,
- bei der Abtasteinheit 22,
- beim ausgehenden ersten Digitalsignal Z1 und
- beim ausgehenden zweiten Digitalsignal Z2.

Im Unterschied zum für die Abtasteinheit 22 bestimmten Takt R durchläuft hierbei der für die eingehenden Analogsignale A1, A2 sowie der für die ausgehenden Digitalsignale Z1, Z2 bestimmte Takt jeweils eine Frequenzteilereinheit 42, die von der Taktgebereinheit 40 getriggert wird und deren Rate 1/N, das heißt im vorliegenden Falle des ersten Ausführungsbeispiels 1/2 beträgt, weil zwei Signalpfade S1, S2 (--> N = 2) gegeben sind.

In Figur 2 ist die Abtasteinheit 22 Teil des Analog/Digital-Wandlers 20 und einer Quantisierungseinheit 50 vorgeschaltet, die ebenfalls im Analog/Digital-Wandler 20 integriert ist und entsprechend der Abtastrate R den jeweiligen zu quantisierenden Abtastwerten der zwei Signalpfade S1, S2 symmetrisch und abwechselnd zugeordnet wird.

Die Vorrichtung 100 gemäß dem ersten Ausführungsbeispiel in Figur 2 kann exemplarisch für zwei gleichartige analoge D[igital]A[udio]B[roadcasting]-Signale A1, A2 mit einer Frequenzbandbreite von jeweils 1,5 Megahertz eingesetzt werden; diese beiden DAB-Signale A1, A2 werden durch die Abtasteinheit 22 mit einer Abtastrate R/N (mit N = 2) von 25 Megahertz abgetastet, so dass die Takt(geber)einheit 40 mit einer Frequenz oder Rate R von fünfzig Megahertz arbeitet.

Somit werden in zuverlässiger Weise Probleme vermieden, die ansonsten bei einem schmalbandigeren zweiten analogen Signal auftreten würden, für das eine niedrigere Abtastrate ausreichen würde (zum Beispiel bei einem zweiten analogen F[requenz]M[odulation]-Signal mit einer Frequenzbandbreite von 0,2 Megahertz).

Beim zweiten Ausführungsbeispiel der vorliegenden Erfindung gemäß Figur 3 wird das erste, in Figur 3 obere Analogsignal A1 in einer einem Analog/Digital-Wandler 20' vorgeschalteten ersten Abtasteinheit 30 unter Erhalt von ersten Abtastwerten abgetastet, wobei die erste Abtasteinheit 30 durch einen ersten Abtasttakt R1 getriggert wird, der von einer Taktgebereinheit 40' geliefert wird.

Aus der Darstellung gemäß Figur 3 ist in diesem Zusammenhang ersichtlich, dass der von der Takt(geber)einheit 40' zur Verfügung gestellte Takt an insgesamt acht Stellen in der Vorrichtung 100' genutzt wird, nämlich

- als erster Abtasttakt R1 bei der ersten Abtasteinheit 30,
- nach Durchlaufen einer der Takt(geber)einheit 40' nachgeschalteten Frequenzteilereinheit 42' als zweiter Abtasttakt R2 bei der zweiten Abtasteinheit 32,
- nach Durchlaufen der Frequenzteilereinheit 42' als zweiter Abtasttakt R2 auf dem ersten Signalpfad S1 vor dem Analog/Digital-Wandler 20',
- nach Durchlaufen der Frequenzteilereinheit 42' als zweiter Abtasttakt R2 auf dem zweiten Signalpfad S2 vor dem Analog/Digital-Wandler 20',
- nach Durchlaufen einer weiteren, der Takt(geber)einheit 40' nachgeschalteten Frequenzteilereinheit 42' als zweiter Abtasttakt R2 auf dem ersten Signalpfad S 1 hinter dem Analog/Digital-Wandler 20',
- nach Durchlaufen der weiteren Frequenzteilereinheit 42' als zweiter Abtasttakt R2 auf dem zweiten Signalpfad S2 hinter dem Analog/Digital-Wandler 20',
- nach Durchlaufen der weiteren Frequenzteilereinheit 42' als zweiter Abtasttakt R2 auf dem ersten Signalpfad S1 bei einer (nachstehend erläuterten) Signalergänzungseinheit 60 und
- als erster Abtasttakt R1 beim ersten digitalen Signalprozessor 10.

Mithin wird das zweite, in Figur 3 untere Analogsignal A2 in einer dem Analog/Digital-Wandler 20' ebenfalls vorgeschalteten und zur ersten Abtasteinheit 30 parallelgeschalteten zweiten Abtasteinheit 32 unter Erhalt von zweiten Abtastwerten abgetastet, wobei die Abtasteinheit 32 durch den zweiten Abtasttakt R2 getriggert wird, der von der Taktgebereinheit 40' geliefert wird und nach Durchlaufen der Frequenzteilereinheit 42' einem rationalen Bruchteil des ersten Abtasttakts R1 entspricht.

Im vorliegenden Falle der Figur 3 beträgt dieser Bruchteil ein Fünftel; dies bedeutet, dass in chronologischer Abfolge jeweils vier von fünf Abtastwerten auf dem ersten Signalpfad S1 (= erster Kanal) und jeder fünfte Abtastwert auf dem zweiten Signalpfad S2 (= zweiter Kanal) im Quantisierer 50' quantisiert werden, wobei diese Quantisierungseinheit 50' am Ausgang des Analog/Digital-Wandlers 20' angeordnet ist.

Mithin ist beim zweiten Ausführungsbeispiel der vorliegenden Erfindung gemäß Figur 3 eine auf die beiden Kanäle S1, S2 verteilte Abtastung und Quantisierung insofern gegeben, als die durch die Abtastrate R2 des zweiten Signalpfads S2 definierten Zeitintervalle, während derer der erste Signalpfad S1 nicht abgetastet bzw. quantisiert wird, zum Abtasten bzw. Quantisieren des zweiten Signalpfads S2 genutzt werden.

Eine Besonderheit des zweiten Ausführungsbeispiels gemäß Figur 3 ist also darin zu sehen, dass im ersten Signalpfad S1 jeder fünfte Wert nicht abgetastet wird, weil in diesem Zeitintervall gerade der zweite Signalpfad S2 abgetastet wird. Dies bedeutet mit anderen Worten, dass von den Abtastwerten des ersten Signals A1 jeder fünfte Wert infolge Nicht-Abtastens fehlt und deshalb zu ersetzen oder zu ergänzen ist.

Dieses Ersetzen bzw. Ergänzen wird mittels einer Signalergänzungseinheit 60 realisiert, die im ersten Signalpfad S 1 zwischen der Quantisierungseinheit 50' und dem ersten digitalen Signalprozessor 10 angeordnet ist. Das Ersetzen bzw. Ergänzen erfolgt, indem die fehlenden fünften Werte des in der Quantisierungseinheit 50' gebildeten ersten Digitalsignals Z1 jeweils durch einen verschwindenden Abtastwert, nämlich durch Null ersetzt werden.

Bei diesem Ersetzen bzw. Ergänzen der fehlenden Werte durch Null werden die Ergebnisse der Signalverarbeitung in nur unwesentlicher, die Qualität des Empfängers nicht beeinträchtigender Weise beeinflußt, denn bei den Analogsignalen A1, A2 wird jeweils nur ein Teil der gesamten Frequenzbandbreite genutzt. In diesem Zusammenhang ist zu bedenken, dass die Abtastrate von der Frequenz des abzutastenden Signals abhängig ist und dem Abtasttheorem unterliegt, wonach eine Signalreproduktion eine Abtastrate voraussetzt, die mindestens doppelt so hoch wie die Frequenz des abzutastenden Signals ist.

Im Falle von normalem Audio mit einem maximalen Frequenzumfang von zwanzig Kilohertz beträgt die Abtastrate (= Abtastfrequenz) zum Beispiel zwischen etwa 44,1 Kilohertz und 48 Kilohertz, bei qualitativ hochwertigem Mehrkanal-Audio kann die Abtastrate bis zu 192 Kilohertz betragen.

Die zeitliche Korrelation zwischen dem Abtasten des zweiten Signalpfads S2 und der der Quantisierungseinheit 50' nachgeschalteten Signalergänzung 60 im ersten Signalpfad S1 ist durch die Taktgebereinheit 40' und durch die weiteren, der Taktgebereinheit 40' nachgeschalteten Frequenzteilereinheiten 42' gegeben; im speziellen wird beim zweiten Ausführungsbeispiel gemäß Figur 3 das Abtasten des zweiten Analogsignals A2 durch die mittels der Frequenzteilereinheiten 42' erzielten Raten R2 mit dem Ersetzen jedes fünften Werts des ersten digitalisierten Signals Z1 zeitlich korreliert.

Das ergänzte und damit "vollständige" erste Digitalsignal Z1 wird abschließend im ersten digitalen Signalprozessor 10 weiterverarbeitet; das in der Quantisierungseinheit 50' ebenfalls gebildete weitere Digitalsignal Z2 wird im zweiten digitalen Signalprozessor 12 weiterverarbeitet.

Die Vorrichtung 100' gemäß dem zweiten Ausführungsbeispiel in Figur 3 kann exemplarisch

- fiir ein erstes analoges D[igital]A[udio]B[roadcasting]-Signal A1 mit einer Frequenzbandbreite von 1,5 Megahertz sowie
- fiir ein zweites analoges F[requenz]M[odulation]-Signal A2 mit einer Frequenzbandbreite von 0,2 Megahertz eingesetzt werden.

Bei einer derartigen Konstellation können der Analog/Digital-Wandler 20' und damit die Quantisierungseinheit 50' mit einer Frequenz von 25 Megahertz (= mit der Frequenz der Taktgebereinheit 40') betrieben werden, so dass

- ein durch die erste Abtasteinheit 30 mit dieser ersten Abtastrate R1 (= 25 Megahertz) abgetastetes und sodann digitalisiertes DAB-Signal Z1, bei dem jeder N-te Wert (= jeder fünfte Wert) gleich Null und damit mittels der Signalergänzungseinheit 60 zu ersetzen ist, sowie
- ein durch die zweite Abtasteinheit 32 mit der zweiten Abtastrate R2 (= fünf Megahertz = erste Abtastrate R1 geteilt durch N) abgetastetes und sodann digitalisiertes FM-Signal Z2

erhalten wird.

Bei der Vorgehensweise gemäß Figur 3 werden mit einem einzigen Analog/Digital-Wandler 20' bei vorgegebener Abtastrate R1 und damit bei gleicher Leistungsaufnahme zwei verschiedene Signale in sehr guter Qualität abgetastet, wobei von Nutzen ist, dass das zweite Analogsignal A2 (im zweiten Ausführungsbeispiel gemäß Figur 3 um den Faktor 7,5) schmalbandiger als das erste Analogsignal A1 ist.

In diesem Zusammenhang ist die erfindungswesentliche Tatsache zu berücksichtigen, dass die Leistungsaufnahme einer Analog/Digital-Wandlereinheit grundsätzlich annähernd proportional zur Abtastrate ansteigt. Im vorliegenden Falle steigt die Leistungsaufnahme der Analog/Digital-Wandlereinheit 20 (= erstes Ausführungsbeispiel gemäß Figur 2) bzw. der Analog/Digital-Wandlereinheit 20' (= zweites Ausführungsbeispiel gemäß Figur 3) trotz der Analog/Digital-Wandlung des zweiten analogen Signals A2 (sowie gegebenenfalls weiterer analoger Signale) vorteilhafterweise nicht an.

Im folgenden sind abschließend anhand von Figur 4 die sich aus einer systemtheoretischen Überlegung ergebenden Bedingungen für eine beim zweiten Ausführungsbeispiel gemäß Figur 3 erfolgende korrekte Signalergänzung bzw. - gewinnung durch Einfügen einer Null an jeder N-ten Stelle (hier: N = 5) des quantisierten ersten Digitalsignals Z1 dargelegt:

Jeder nicht vom Quantisierer 50' (vgl. Figur 3) gelieferte N-te Wert des in die Signalergänzungseinheit 60 eingehenden quantisierten Signals Z1:x(n) wird mit Null, das heißt mit einem verschwindenden Wert ersetzt. Das die Signalergänzungseinheit 60 verlassende Ausgangsignal Z1:y(n) läßt sich im Frequenzbereich (<--> Frequenz f = Winkelgeschwindigkeit ω / 2π) folgendermaßen beschreiben:

$$Y(e^{j\omega}) = X(e^{j\omega}) - V(e^{j\omega}) = \frac{N-1}{N}X(e^{j\omega}) - \frac{1}{N}\sum_{i=1}^{N-1}X(e^{j(\omega-\frac{2\pi}{N}i)})$$

Die vorstehende Gleichung enthält eine additive Fehlerkomponente V(e$^{j\omega}$). Wenn N die Bedingung

$$\frac{Fs \cdot i}{2IF - B} \leq N \geq \frac{Fs \cdot i}{2IF + B}, i = 1,2,...N-1$$

erfüllt (Fs = Bandbreite), dann überlappt sich der Fehleranteil im Spektrum nicht mit dem Nutzsignal, das in mindestens einem nachfolgenden obligatorischen Kanalfilter herausgefiltert werden kann.

Die vorstehend anhand der Figuren 2 bis 4 erläuterte Erfindung findet exemplarische Anwendung in digitalen Kommunikationssystemen, insbesondere in digitalen Rundfunkempfangssystemen.

**Patentansprüche**

1. Vorrichtung (100; 100') zum Wandeln von mindestens zwei parallel eingehenden Analogsignalen (A1, A2) mittels digitaler Signalprozessoren (10, 12) zu verarbeitenden Digitalsignalen (Z1, Z2), wobei mindestens ein erstes Analogsignal (A1) der eingehenden Analogsignale (A1, A2) mindestens einem ersten Signalpfad (S1) zuordbar ist und mindestens ein weiteres, insbesondere mindestens ein zweites, Analogsignal (A2) der eingehenden Analogsignale (A1, A2) mindestens einem weiteren, insbesondere mindestens einem zweiten, Signalpfad (S2) zuordbar ist,

   - wobei die mindestens zwei Analogsignale (A1, A2) mittels eines Analog/Digital-Wandlers (20; 20') gleichzeitig wandelbar sind,
   - wobei mindestens eine Abtasteinheit (22; 30, 32) zum Abtasten der jeweiligen Analogsignale (A1, A2) unter Erhalt von jeweiligen Abtastwerten vorgesehen ist, wobei der erste Signalpfad (S1) und der weitere, insbesondere zweite, Signalpfad (S2) mit jeweils einer von mindestens einer Taktgebereinheit (40; 40') erzeugten Rate (R; R1, R2), insbesondere Abtastrate, betreibbar sind,
   - wobei der Analog/Digital-Wandler (20; 20') eine der Abtasteinheit (22; 30, 32) nachgeschaltete Quantisierungseinheit (50; 50') aufweist, die den jeweiligen zu quantisierenden Abtastwerten entsprechend der Rate (R), insbesondere Abtastrate, bzw. entsprechend den Raten (R1, R2), insbesondere Abtastraten, der mindestens zwei Signalpfade (S1, S2) zuordbar ist und
   - **dadurch gekennzeichnet, dass** die Rate (R2), insbesondere Abtastrate, des weiteren, insbesondere zweiten, Signalpfads (S2) einem von mindestens einer Teilereinheit (42'), insbesondere von mindestens einer Frequenzteilereinheit, erzeugten, insbesondere rationalen (1/N), Bruchteil der Rate (R1), insbesondere Abtastrate, des ersten Signalpfads (S1) entspricht.

2. Vorrichtung gemäß Anspruch 1, **dadurch gekennzeichnet,**

   - **dass** im ersten Signalpfad (S1) mindestens eine Signalergänzungseinheit (60) angeordnet ist,

- dass mittels der Signalergänzungseinheit (60) infolge Nicht-Abtastens fehlende Werte

-- ersetzbar, insbesondere durch Null ersetzbar, oder
-- ergänzbar, insbesondere durch interpolierte Werte ergänzbar,

sind, wobei die zeitliche Korrelation zwischen dem Abtasten des weiteren, insbesondere zweiten, Signalpfads (S2) und der insbesondere der Quantisierungseinheit (50') nachgeschalteten Signalergänzungseinheit (60) durch die Taktgebereinheit (40') sowie durch mindestens eine weitere, die Signalergänzungseinheit (60) mit der Rate (R2) beaufschlagende Teilereinheit (42') gegeben ist, und

- **dass** in den durch die Rate (R2), insbesondere Abtastrate, des weiteren, insbesondere zweiten, Signalpfads (S2) definierten Zeitintervallen, während derer der erste Signalpfad (S1) nicht abgetastet wird, der weitere, insbesondere zweite, Signalpfad (S2) abtastbar ist.

**3.** Schaltungsanordnung, insbesondere integrierter Schaltkreis, beinhaltet eine Vorrichtung (100; 100') gemäß einem der Ansprüche 1 oder 2.

**4.** Verfahren zum Wandeln von mindestens zwei parallel eingehenden Analogsignalen (A1, A2) mittels digitaler Signalprozessoren (10, 12) zu verarbeitenden Digitalsignalen (Z1, Z2), wobei mindestens ein erstes Analogsignal (A1) der eingehenden Analogsignale (A1, A2) mindestens einem ersten Signalpfad (S1) zugeordnet wird und mindestens ein weiteres, insbesondere mindestens ein zweites, Analogsignal (A2) der eingehenden Analogsignale (A1, A2) mindestens einem weiteren, insbesondere mindestens einem zweiten, Signalpfad (S2) zugeordnet wird,

- wobei die mindestens zwei Analogsignale (A1, A2) mittels eines Analog/Digital-Wandlers (20, 20') gleichzeitig gewandelt werden,
- wobei das erste Analogsignal (A1) in einer ersten Abtasteinheit (30) mit einer ersten Rate (R1), insbesondere mit einer ersten Abtastrate, unter Erhalt von ersten Abtastwerten abgetastet wird, und wobei das weitere, insbesondere zweite, Analogsignal (A2) in mindestens einer weiteren, insbesondere in mindestens einer zweiten, Abtasteinheit (32) mit einer weiteren, insbesondere zweiten, Rate (R2), insbesondere Abtastrate, unter Erhalt von weiteren, insbesondere zweiten, Abtastwerten abgetastet wird
- wobei in einer Quantisierungseinheit (50) für sämtliche Signalpfade (S1, S2) die Abtastwerte in Form der Digitalsignale (Z1; Z2) quantisiert werden und
- wobei die Digitalsignale (Z1; Z2) in den jeweiligen digitalen Signalprozessoren (10, 12) verarbeitet, insbesondere weiterverarbeitet, werden und
- **dadurch gekennzeichnet, dass** die Rate (2), insbesondere die Abtastrate, des weiteren, insbesondere zweiten, Signalpfades (S2) so gewählt wird, dass sie einem Bruchteil der Rate (R1), insbesondere Abtastrate, des ersten Signalpfades (S1) entspricht.

**5.** Verfahren gemäß Anspruch 4, **dadurch gekennzeichnet, dass** die durch die weitere, insbesondere zweite, Rate (R2) einem insbesondere rationalen (1/N) Bruchteil der ersten Rate (R1) entspricht, so dass die durch die weitere; insbesondere zweite, Rate (R2) definierten Zeitintervalle, während derer das erste Analogsignal (A1) nicht abgetastet wird, zum Abtasten des weiteren, insbesondere zweiten, Analogsignals (A2) genutzt werden,

- dass in einer Quantisierungseinheit (50') die ersten Abtastwerte sowie die weiteren, insbesondere zweiten, Abtastwerte quantisiert werden,
- **dass** infolge Nicht-Abtastens fehlende Werte des in der Quantisierungseinheit (50') gebildeten ersten Digitalsignals (Z1: x(n)) mittels mindestens einer Signalergänzungseinheit (60) unter Bildung eines vollständigen ersten Digitalsignals (Z1: y(n))

-- ersetzt, insbesondere durch Null ersetzt, oder
-- ergänzt, insbesondere durch interpolierte Werte ergänzt,

werden, wobei das Abtasten des weiteren, insbesondere zweiten, Analogsignals (A2) und die insbesondere der Quantisierungseinheit (50') nachgeschaltete Signalergänzung des ersten Digitalsignals (Z1) durch mindestens eine Taktgebereinheit (40') sowie durch mindestens eine weitere, die Signalergänzungseinheit (60) mit der Rate (R2) beaufschlagende Teilereinheit (42'), insbesondere Frequenzteilereinheit, zeitlich korreliert wird,
- **dass** das vollständige erste Digitalsignal (Z1: y(n)) im ersten digitalen Signalprozessor (10) verarbeitet, insbesondere weiterverarbeitet, wird und
- dass das in der Quantisierungseinheit (50') gebildete weitere, insbesondere zweite, Digitalsignal (Z2) im weiteren, insbesondere zweiten, digitalen Signalprozessor (12) verarbeitet, insbesondere weiterverarbeitet, wird,

wobei die Ergebnisse der Verarbeitung des ersten Digitalsignals (Z1) im Falle des Ersetzens der fehlenden Werte durch Null nicht beeinflußt werden, wenn bei den Analogsignalen (A1, A2) jeweils nur ein Teil der gesamten Frequenzbandbreite genutzt wird.

6. Verwendung mindestens einer Vorrichtung (100; 100') gemäß mindestens einem der Ansprüche 1 oder 2 und/oder mindestens einer Schaltungsanordnung gemäß Anspruch 3 und/oder eines Verfahrens gemäß einem der Ansprüche 4 oder 5 in digitalen Kommunikationssystemen, insbesondere in digitalen Rundfunkempfangssystemen.

**Claims**

1. Apparatus (100; 100') for converting at least two analogue signals (A1, A2) received in parallel into digital signals (Z1, Z2) which are to be processed by means of digital signal processors (10, 12), where at least one first analogue signal (A1) from the received analogue signals (A1, A2) can be associated with at least one first signal path (S1), and at least one further, particularly at least one second analogue signal (A2) from the received analogue signals (A1, A2) can be associated with at least one further, particularly at least one second signal path (S2),

   - where the at least two analogue signals (A1, A2) can be converted simultaneously by means of an analogue/digital converter (20; 20'),
   - where at least one sampling unit (22; 30, 32) for sampling the respective analogue signals (A1, A2) to obtain respective samples is provided, the first signal path (S1) and the further, particularly second, signal path (S2) being able to be operated at a respective rate (R; R1, R2), particularly sampling rate, produced by at least one clock generator unit (40; 40'),
   - where the analogue/digital converter (20; 20') has a quantization unit (50; 50') which is connected downstream of the sampling unit (22; 30, 32) and which can be associated with the respective samples to be quantized on the basis of the rate (R), particularly sampling rate, or on the basis of the rates (R1, R2), particularly sampling rates of the at least two signal paths (S1, S2), and
   - **characterized in that** the rate (R2), particularly sampling rate, of the further, particularly second, signal path (S2) corresponds to a fraction, particularly a rational fraction (1/N), of the rate (R1), particularly sampling rate, of the first signal path (S1), said fraction being produced by at least one divider unit (42'), particularly by at least one frequency divider unit.

2. Apparatus according to Claim 1, **characterized**

   - **in that** the first signal path (S1) contains at least one signal complementing unit (60),
   - **in that** the signal complementing unit (60) can be used

      -- to replace values which are missing as a result of not being sampled particularly to replace them with zero, or
      -- to complement values which are missing as a result of not being sampled, particularly to complement them with interpolated values,

   where the time correlation between the sampling of the further, particularly second, signal path (S2) and the signal complementing unit (60), particularly connected downstream of the quantization unit (50'), is given by the clock generator unit (40') and by at least one further divider unit (42') which applies the rate (R2) to the signal complementing unit (60), and
   - **in that** the time intervals which are defined by the rate (R2), particularly sampling rate, of the further, particularly second signal path (S2) and during which the first signal path (S1) is not sampled can be used to sample the further, particularly second signal path (S2).

3. Circuit arrangement, particularly integrated circuit, containing an apparatus (100; 100') according to one of Claims 1 and 2.

4. Method for converting at least two analogue signals (A1, A2) received in parallel into digital signals (Z1, Z2) which are to be processed by means of digital signal processors (10, 12), where at least one first analogue signal (A1) from the received analogue signals (A1, A2) is associated with at least one first signal path (S1), and at least one further, particularly at least one second, analogue signal (A2) from the received analogue signals (A1, A2) is associated with at least one further, particularly at least one second signal path (S2),

- where the at least two analogue signals (A1, A2) are converted simultaneously by means of an analogue/ digital converter (20, 20'),
- where the first analogue signal (A1) is sampled in a first sampling unit (30), at a first rate (R1), particularly at a first sampling rate to obtain first samples, and where the further, particularly second, analogue signal (A2) is sampled in at least one further, particularly in at least one second, sampling unit (32) at a further, particularly second, rate (R2), particularly sampling rate, to obtain further, particularly second, samples,
- where a quantization unit (50) for all signal paths (S1, S2) quantizes the samples in the form of the digital signals (Z1; Z2), and
- where the digital signals (Z1; Z2) are processed, particularly processed further, in the respective digital signal processors (10, 12), and
- **characterized in that** the rate (2), particularly the sampling rate of the further, particularly second, signal path (S2) is chosen such that it corresponds to a fraction of the rate (R1), particularly sampling rate, of the first signal path (S1).

5. Method according to Claim 4, **characterized in that** the further, particularly second, rate (R2) corresponds to a fraction, particularly a rational fraction (1/N) of the first rate (R1), so that the time intervals which are defined by the further, particularly second, rate (R2) and during which the first analogue signal (A1) is not sampled are used to sample the further, particularly second, analogue signal (A2),

- **in that** a quantization unit (50') quantizes the first samples and also the further, particularly second, samples,
- **in that** values of the first digital signal (Z1: x(n)) formed in the quantization unit (50') which are missing as a result of not being sampled are:

-- replaced, particularly replaced with zero, or
-- complemented, particularly complemented with interpolated values,

by means of at least one signal complementing unit (60) to form a complete first digital signal (Z1: y(n)), where the sampling of the further, particularly second, analogue signal (A2) and the signal complementing, particularly connected downstream of the quantization unit (50'), for the first digital signal (Z1) are time-correlated by at least one clock generator unit (40') and by at least one further divider unit (42'), particularly frequency divider unit, which applies the rate (R2) to the signal complementing unit (60),
- **in that** the complete first digital signal (Z1: y(n)) is processed, particularly processed further, in the first digital signal processor (10), and
- **in that** the further, particularly second, digital signal (Z2) formed in the quantization unit (50') is processed, particularly processed further, in the further, particularly second digital signal processor (12),

where the results of the processing of the first digital signal (Z1) when the missing values are replaced with zero are not influenced if only a respective portion of the entire frequency bandwidth is used for the analogue signals (A1, A2).

6. Use of at least one apparatus (100; 100') according to at least one of Claims 1 and 2 and/or of at least one circuit arrangement according to Claim 3 and/or of a method according to one of Claims 4 and 5 in digital communication systems, particularly in digital broadcast radio reception systems.

**Revendications**

1. Dispositif (100, 100') pour convertir au moins deux signaux analogiques d'entrée (A1, A2) par des processeurs numériques de signaux (10, 12) pour obtenir des signaux numériques à traiter (Z1, Z2),

- au moins un premier signal analogique (A1) des signaux analogiques d'entrée (A1, A2) étant associé à au moins un premier chemin de signal (S1) et au moins un autre, notamment au moins un second signal analogique (A2) des signaux analogiques d'entrée (A1, A2) étant associé à au moins un autre, notamment au moins un second chemin de signal (S2),

- au moins les deux signaux analogiques (A1, A2) étant convertis en même temps par un convertisseur analogique/numérique (20, 20'),

- au moins une unité de détection (22 ; 30, 32) détectant les signaux analogiques respectifs (A1, A2) pour obtenir les valeurs de détection respectives, le premier chemin de signal (S1) et l'autre notamment le second chemin de signal (S2), fonctionnant avec chaque fois une vitesse (R, R1, R2) notamment une vitesse de détection générée par au moins une unité d'horloge (40, 40'),

- le convertisseur analogique/numérique (20, 20') ayant une unité de quantification (50, 50') en aval de l'unité de détection (22 ; 30, 32), cette unité de quantification étant associée selon les valeurs de détection à quantifier respectivement suivant la vitesse (R) notamment les vitesses de détection ou selon les vitesses (R1, R2) notamment les vitesses de détection à au moins deux chemins de signal (S1, S2),

**caractérisé en ce que**
la vitesse (R2) notamment la vitesse de détection de l'autre chemin de signal (S2), notamment du second chemin de signal, correspond à une fraction notamment la fraction rationnelle (1/N) de la vitesse (R1) notamment de la vitesse de détection du premier chemin de signal (S1), fraction fournie par au moins une unité de division (42'), notamment par au moins une unité de division de fréquence.

2. Dispositif selon la revendication 1,
**caractérisé en ce qu'**
au moins une unité de complément de signal (60) est prévue dans le premier chemin de signal (S1),

- à l'aide de l'unité de complément de signal (60), on remplace les valeurs manquantes par non détection notamment on remplace le zéro, et

- on complète notamment par des valeurs d'interpolation, la corrélation dans le temps entre la détection de l'autre chemin notamment du second chemin de signal (S2) et notamment de l'unité de complément de signal (60) en aval de l'unité de quantification (50') sont données par l'unité d'horloge (40') et par au moins une autre unité de division (42') qui applique la vitesse (R2) à l'unité de complément de signal (60), et

- dans les intervalles de temps définis par la vitesse (R2) notamment la vitesse de détection de l'autre chemin de signal (S2) notamment du second chemin de signal, pendant lesquels le premier chemin de signal (S1) n'est pas détecté, on détecte l'autre chemin de signal (S2) notamment le second chemin de signal.

3. Circuit notamment circuit intégré comportant un dispositif (100, 100'),
selon l'une quelconque des revendications 1 ou 2.

4. Procédé de conversion d'au moins deux signaux analogiques entrant (A1, A2), parallèles, par des processeurs numériques de signaux (10, 12) pour obtenir des signaux numériques (Z1, Z2) à traiter,
au moins un premier signal analogique (A1) parmi les signaux analogiques entrant (A1, A2) étant associés à au moins un premier chemin de signal (S1) et au moins un autre signal analogique (A2) notamment au moins un second signal analogique parmi les signaux analogiques entrant (A1, A2) étant appliqués à au moins un autre chemin de signal (S2), notamment à au moins un second chemin de signal (S2), et

- au moins les deux signaux analogiques (A1, A2) sont convertis simultanément par un convertisseur analogique/numérique (20, 20'),

- le premier signal analogique (A1) étant détecté dans une première unité de détection (30) selon une première vitesse (R1) notamment à une première vitesse de détection pour obtenir les premières valeurs de détection, et l'autre signal analogique (A2), notamment le second signal analogique est détecté dans au moins une autre unité de détection (32) notamment au moins une seconde unité de détection (32) avec une autre vitesse (R2) notamment une seconde vitesse, notamment la vitesse de détection pour obtenir d'autres valeurs de détection notamment des secondes valeurs de détection, et

- dans une unité de quantification (50) pour tous les chemins de signal (S1, S2), on quantifie les valeurs de détection sous la forme de signaux numériques (Z1, Z2), et

- les signaux numériques (Z1, Z2) sont traités dans les processeurs numériques de signaux respectifs (10, 12), notamment on poursuit leur traitement,

**caractérisé en ce qu'**

- on choisit la vitesse (2), notamment la vitesse de détection de l'autre chemin de signal (S2) notamment du second chemin de signal de façon à correspondre à une fraction de la vitesse (R1) notamment de la vitesse de détection du premier chemin de signal (S1).

5. Procédé selon la revendication 4,
**caractérisé en ce que**
l'autre vitesse (R2) notamment la seconde vitesse correspond notamment à une fraction rationnelle (1/N) de la première vitesse (R1) de façon que les intervalles de temps définis par l'autre vitesse (R2) notamment la seconde vitesse (R2) soit utilisés pour détecter l'autre signal analogique (A2), notamment le second signal analogique pendant que le premier signal analogique (A1) n'est pas détecté,

- dans une unité de quantification (50') on quantifie les premières valeurs de détection ainsi que les autres valeurs de détection notamment les secondes,
- les valeurs manquantes par non détection dans le premier signal numérique (Z1 : x(n)) formées dans l'unité de quantification (50'), sont remplacées par au moins une unité de complément de signal (60) en formant un premier signal numérique complet (Z1 : y(n)),
- on remplace notamment par zéro, ou
- on complète notamment par des valeurs interpolées, et
la détection de l'autre signal analogique (A2) notamment du second signal analogique et le complément de signal du premier signal numérique (Z1), notamment par l'unité de quantification (50') en aval, est mise en corrélation de temps par au moins une unité d'horloge (40') et par au moins une autre unité de division (42') appliquant la vitesse (R2) à l'unité de complément de signal (60),
- le premier signal numérique complet (Z1; y(n)) étant traité dans le premier processeur de signal numérique (10) notamment son traitement étant poursuivi, et
- l'autre signal numérique (Z2) notamment le second signal numérique formé dans l'unité de quantification (50'), est traité ensuite notamment son traitement est poursuivi dans le second processeur numérique de signal (12),

les résultats du traitement du premier signal numérique (Z1) n'étant pas influencés dans le cas où les valeurs manquantes sont remplacées par zéro, si pour les signaux analogiques (A1, A2) on utilise chaque fois selon une partie de l'ensemble de la largeur de bande de fréquence.

6. Utilisation d'au moins un dispositif (100, 100') selon au moins 'l'une quelconque des revendications 1 ou 2 et/ ou au moins un circuit selon la revendication 3 et/ou un procédé selon l'une quelconque des revendications 4 ou 5 dans les systèmes de communication numérique notamment des systèmes numériques de réception radio.

Fig.1

Fig. 2

# Fig.3

# Fig. 4

**IN DER BESCHREIBUNG AUFGEFÜHRTE DOKUMENTE**

**In der Beschreibung aufgeführte Patentdokumente**

- WO 03055207 A
- DE 10042959 C1